Europäisches Patentamt

European Patent Office

Office européen des brevets

(19)

(11) Publication number: **0 043 691**
**B1**

(12) **EUROPEAN PATENT SPECIFICATION**

(45) Date of publication of patent specification: **28.05.86**

(21) Application number: **81302968.3**

(22) Date of filing: **30.06.81**

(51) Int. Cl.⁴: **H 01 L 29/04,** H 01 L 21/203,
H 01 L 27/12

(54) **Semiconductor device having a polycrystalline semiconductor film.**

(30) Priority: **03.07.80 JP 91001/80**

(43) Date of publication of application:
**13.01.82 Bulletin 82/02**

(45) Publication of the grant of the patent:
**28.05.86 Bulletin 86/22**

(84) Designated Contracting States:
**DE FR GB NL**

(56) References cited:
EP-A-0 023 021
US-A-4 152 535

JOURNAL OF THE ELECTROCHEMICAL
SOCIETY, Vol. 127, No. 3, March 1980
Manchester KAMING "Structure and Properties
of LPCVD Silicon Films" pages 686 to 690

The file contains technical information
submitted after the application was filed and
not included in this specification

(73) Proprietor: **Hitachi, Ltd.**
**5-1, Marunouchi 1-chome**
**Chiyoda-ku Tokyo 100 (JP)**

(72) Inventor: **Matsui, Makoto**
**2-14-10 Kita**
**Kunitachi-shi Tokyo (JP)**
Inventor: **Shiraki, Yasuhiro**
**1-106, 3-26-1 Hirayama**
**Hino-shi Tokyo (JP)**
Inventor: **Katayama, Yoshifumi**
**1303-9 Shimotomi**
**Tokorozawa-shi Saitama-ken (JP)**
Inventor: **Kobayashi, Keisuke**
**1221-2-313 Kunugida-cho Hachioji-shi**
**Tokyo (JP)**
Inventor: **Maruyama, Eiichi**
**1572-3 Josuihoncho**
**Kodaira-shi Tokyo (JP)**

(74) Representative: **Paget, Hugh Charles Edward**
**et al**
**MEWBURN ELLIS & CO. 2/3 Cursitor Street**
**London EC4A 1BQ (GB)**

(58) References cited:

APPLIED PHYSICS LETTERS, Vol. 35, No. 9,
November 1979 New York MORIN et al.
"Polycrystalline Silicon by Glow Discharge
Technique" pages 686 to 687

THIN SOLID FILMS, Vol. 35, No. 1, 1st June
1976 Lausanne GOROHOV et al
"Characteristics of Polycrystalline Silicon
Integrated Circuits" pages 149 to 153

## Description

This invention relates to a semiconductor device employing a polycrystalline semiconductor film on a substrate.

In recent years, development of an elongate active device array and of a large area active device array has been sought. These active devices are intended to be used as a photosensor for reading a picture in a facsimile transmitter, and for the driver circuit of a liquid crystal display panel or electroluminescence display panel which serves as a flat display panel to replace a cathode-ray tube.

Ordinary semiconductor devices employing a single crystal of silicon are limited in size by the size of the single crystal silicon wafer serving as a parent material. On the other hand, thin film transistors etc. have been attempted, but none has yet attained satisfactory characteristics.

Examples of polycrystalline silicon devices are described in the following references. None of these devices, however, can achieve satisfactory characteristics if formed as a film at a low temperature. No semiconductor device having satisfactory characteristics has been realized on a glass substrate or the like.

(1) Thin Solid Films, vol. 35, June 1976, No. 2, pp. 149—153,

(2) Electrical Design News, vol. 18, No. 13, July 1973, pp. 30—31

(3) IBM Technical Disclosure Bulletin, vol. 14 No. 10, March 1972, pp. 2900—2901,

(4) Applied Physics Letters, vol. 35, 15th July 1979, No. 2, pp. 173—175,

(5) IBM Technical Disclosure Bulletin, vol. 17 No. 8, January 1975, pp. 2455—2456

(6) Solid State Electronics, vol. 15, No. 10 October 1972, pp. 1103—1106.

In Journal of the Electrochemical Society, Vol. 127, March 1980, No. 3, pages 686—690 the production of silicon films having various crystallite orientations by low pressure chemical vapour deposition is described. Properties of the different films are discussed.

An object of this invention is to provide a thin film semiconductor device which can be produced even under low temperature conditions, such as a deposition temperature of, for example, below 700°C, and which exhibits good operating characteristics.

The present invention is defined in the claims.

With the present invention, a semiconductor device can be produced on a substrate made of glass or the like having a comparatively low softening point, and an evaporation process can be used, allowing large area or elongate semiconductor devices to be fabricated readily.

The polycrystalline semiconductor film may be formed by vacuum evaporation under a high vacuum of below $1 \times 10^{-8}$ Torr $(1.3 \times 10^{-6} Pa)$ pressure. In the evaporation a deposition temperature of 400—700°C may suffice.

An embodiment of this invention will now be described by way of example, with reference to the accompanying drawings, in which :—

Figure 1 is a graph showing the relationship between the thickness and grain size of an evaporated film,

Figures 2a—2h are sectional views showing a process for producing a MOSFET (metal-oxide-semiconductor field effect transistor) using a polycrystalline semiconductor film, and

Figure 3 is a graph showing the drain current—versus—drain voltage characteristic of a MOSFET embodying this invention.

In our patent application No. EP—A—23021 we describe a technique for producing a semiconductor device using a silicon film produced by evaporation under ultra-high vacuum.

We have made further investigations of the crystallinity of a polycrystalline silicon film formed by the evaporation in the ultra-high vacuum, and information described below has been obtained. It has also been discovered that improvement of operating characteristics can be achieved. The formation of a thin film in ultra-high vacuum is the best process among those presently available for forming thin films, but as regards essential points, the results obtained apply similarly to the thin films produced by the other processes. Likewise, although the results referred to concern silicon film the same applies to different semiconductor films, such as germanium etc.

In the initial stage of the growth of a film, the portion which has initially adhered as an amorphous layer is subject to crystal growth and turns polycrystalline with the subsequent growth of the film. When the film has been formed to a sufficient thickness, it crystallizes and a polycrystalline layer grows from the beginning. From this, it can be understood that a factor hindering crystallization exists in the vicinity of the interface between a substrate and the silicon film. It is accordingly concluded that, even when in the vicinity of the interface owing to the subsequent growth of the film crystallization has occurred so that the whole layer becomes polycrystalline, the crystallinity in the vicinity of the interface is worse than that of the surface layer of the film. In order to produce a good thin-film semiconductor device, it is thus desirable to arrange a channel on the surface side having better crystallinity.

If the silicon film is grown by evaporation at a substrate temperature of 400°C—700°C in ultra-high vacuum, crystal grains whose {100} faces are substantially parallel to the substrate plane and crystal grains whose {110} faces are substantially parallel to the substrate plane coexist in the surface layer if the film thickness is at least 0.5 μm. When the thickness of the film exceeds 1 μm, the growth can be controlled so that the crystal grains whose {100} faces are substantially parallel to the substrate plane becomes overwhelmingly more numerous within the surface layer. In this specification, the state in which the crystal grains with {100} faces substantially parallel to the substrate plane are predominant shall be termed the "<100> preferred orientation" (sometimes expressed as the {100} texture).

A semiconductor device using a polycrystalline semiconductor film whose major surface is a surface having the <100> preferred orientation has good characteristics. In addition, the variations of the characteristics can be reduced. Although a polycrystalline semiconductor film of the <100> preferred orientation is most preferable, a polycrystalline semiconductor film having the mixed preferred orientation of <100> and <110> may be useful. As previously stated, it is favourable that a region in which carriers move (for example, the channel in the FET) is disposed on the surface side of the polycrystalline film. The structure of the film can be fully confirmed by electron diffraction, or X-ray diffraction. Silicon, germanium etc. which are semiconductor materials having the diamond structure exhibit the same tendency.

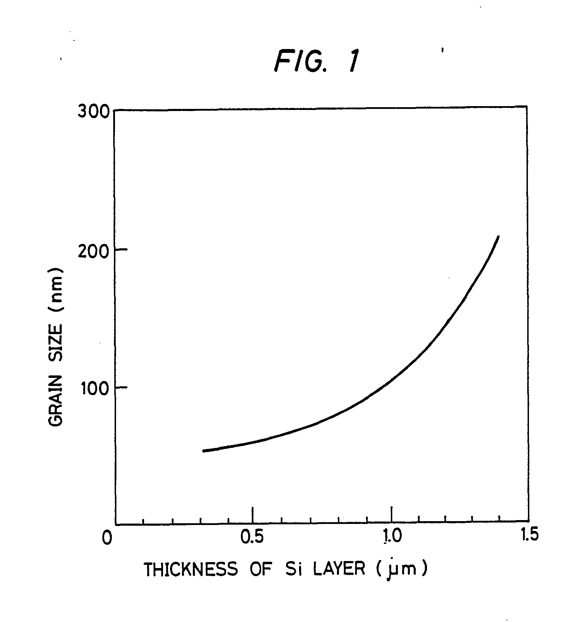

Figure 1 shows the dependency of grain size in the surface layer on the thickness of the film. Since, in the temperature range mentioned above, the substrate temperature-dependency of the grain size may be considered almost nil, a case where the substrate temperature is 600°C is typically illustrated in Figure 1. The illustrated curve corresponds to results obtained by measuring the grain size in the thickness direction of an evaporated film 1.4 μm thick.

The foregoing study of the structure and grain size of a polycrystalline film shows that the grain size can be increased and the structure can be made more favourable by increasing the thickness of the film. A film thickness of at least 0.5 μm may be used for semiconductor devices. A film thickness of at least 1 μm is more preferred. The polycrystalline semiconductor film thus obtained can have a carrier mobility of at least 1 cm$^2$/V·sec.

Needless to say, an impurity can be present in the film as may be needed.

The substrate can be an amorphous or polycrystalline substrate such as glass or $Al_2O_3$ or the like ceramics. A glass substrate is most useful from the point of view of price. A light-transmitting substrate can also be used, e.g. as the substrate of a photodiode or the like in which light enters the substrate side.

One method of producing the polycrystalline semiconductor film of a device according to this invention is as follows.

A vacuum evaporator which can achieve ultra-high vacuum may be a conventional evaporator having an ultra-high vacuum device.

The degree of vacuum during evaporation is made as high as less than $1 \times 10^{-8}$ Torr ($1.3 \times 10^{-6}$ Pa) pressure. $O_2$ especially in the gas remaining during evaporation affects the characteristics of the product adversely, and hence the partial pressure of oxygen is preferably made less than $1 \times 10^{-9}$ ($1.3 \times 10^{-7}$ Pa) Torr.

The deposition rate is preferably in the range 1,000 Å/hour to 10,000 Å/hour (100 nm/hour to 1000 nm/hour).

In order to fabricate a semiconductor device by working the polycrystalline silicon film several steps must be performed. Heat-treatment temperatures in these steps have been kept lower than 820°C which is the softening point of very hard glass. This is because the present invention is most useful for producing a semiconductor device on a glass substrate or the like. If employing a glass substrate of low softening point, it is also possible to keep the temperatures still lower, for example to be below 550°C.

A MOS field effect transistor will now be described as an example of a semiconductor device of the invention.

To form a gate insulator, thermal oxidation of a silicon substrate is generally relied on. Since, however, thermal oxidation requires a temperature of at least 1,000°C, it cannot be used for the present purpose. Therefore, an $SiO_2$ film is formed by chemical vapor deposition by reacting $SiH_4$ and $O_2$ at a temperature of at least 300°C and at most 500°C or by reacting $SiH_4$ and $NO_2$ at a temperature of at least 400°C and at most 800°C and the $SiO_2$ film thus formed is employed as the gate insulator. $SiO_2$ films formed by chemical vapor deposition have in the past been used for passivation, and no example has been employed as the gate insulator.

DE—B—2063726 discloses the production of an $SiO_2$ gate insulator layer by glow discharge is oxygen specifically by glow treatment of a silicon body.

p$^+$ impurity-diffused layers or n$^+$ impurity-diffused layers have previously been made by thermal diffusion in order to form a source region and a drain region. Since, however, this requires a heat treatment at about 1,150°C it cannot be used for the present purpose. The present invention can employ a method in which p$^+$ impurity layers or n$^+$ impurity layers are formed by ion implantation instead of the thermal diffusion. After ion implantation, a heat treatment is conducted for electrical activation, the heat-treatment temperature being kept below the softening point of the substrate used. For instance, there can be implanted ions. e.g. $BF_2^+$ which can be highly activated by a heat treatment at a low temperature of approximately 550°C and B$^+$ ions, and thereafter heat treatment can be performed at a temperature of approximately 500°C—600°C immediately before the reverse anneal phenomenon occurs. While P$^+$ ions, As$^+$ ions etc. are not so good as B$^+$ ions from the point of view of the reverse anneal phenomenon, they can be sufficiently activated by heat treatment at approximately 500°C—600°C. Accordingly, both the p$^+$ impurity layers and the n$^+$ impurity layers can be formed with a low-temperature step of 500°C—600°C or so. Of course, the heat treatment may well be carried out at a temperature of 800°C if a substrate, such as very hard glass substrate, with a softening point higher than 800°C is used.

With this method of manufacture, it is possible to obtain a semiconductor device of large area or great length in which the mobility of carriers is at least 1 $cm^2$/V·sec.

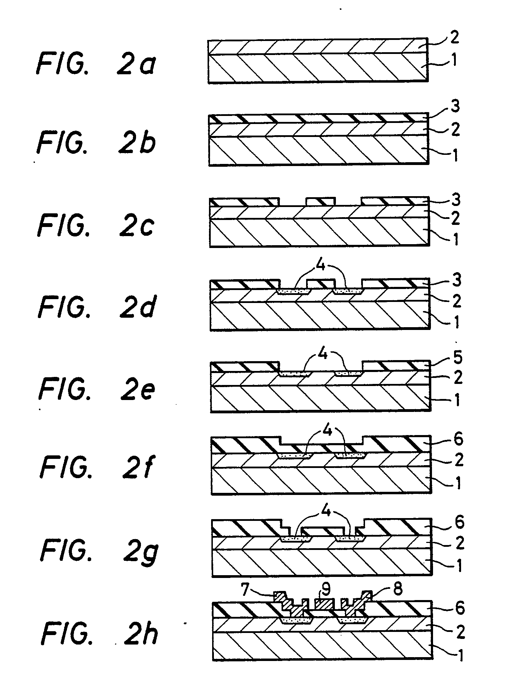

The embodiment of this invention shown in Figures 2a—2h, will now be described. In this case, an n-channel MOS field effect transistor is fabricated by forming a polycrystalline silicon film on a glass substrate and providing channel in the surface layer of the film.

First, the substrate is installed in a vacuum evaporator which can achieve ultra-high vacuum. The evaporator may be a conventional one. A silicon film 2 is deposited to a thickness of 1 μm on the substrate 1 of hard glass (Corning 7059 Glass) by performing vacuum evaporation under the conditions of a substrate temperature of 600°C, a degree of vacuum during evaporation of $8 \times 10^{-9}$ Torr ($1 \times 10^{-6}$ Pa), a partial pressure of oxygen during evaporation of $1 \times 10^{-10}$ Torr ($1.3 \times 10^{-8}$ Pa), and a deposition rate of 5,000 Å/hour (500 nm/hour) (Figure 2a). The silicon film 2 formed is of p-type polycrystalline silicon slightly doped with boron, and has a carrier mobility of about 2 $cm^2$/V·sec. When the crystalline structure in the surface layer of this film was investigated, it was found that the polycrystalline silicon film had a strong <100> preferred orientation and that the <110> preferred orientation coexisted weakly. In other words, it was found that, in the surface layer, predominantly the crystal grains constituting the polycrystalline film had their {100} faces or faces close thereto located parallel to the substrate plane, while some crystal grains whose {110} faces or faces close thereto were parallel to the substrate plane coexisted. It was conjectured that at least half of the grains had their {100} faces located parallel to the major surface of the substrate.

Subsequently, an $SiO_2$ film 3 is deposited to a thickness of 5,000 Å (500 nm) at a substrate temperature of 400°C by chemical vapor deposition (Figure 2b). Then, as shown in Figure 2c, the $SiO_2$ film 3 is provided with windows for source and drain regions. The size of each window was 300×200 (μm) and the gate length was 20 μm. Subsequently $p^+$ ions at an energy level of 100 keV are implanted at a dosage of $1 \times 10^{16}$/$cm^2$, and the resultant substrate is heat-treated at 600°C in an $N_2$ atmosphere for 30 minutes, to form $n^+$ layers 4 in the source and drain regions (Figure 2d). The depth of each $n^+$ layer was 2,000 Å (200 nm).

In the next step, the $SiO_2$ is removed to leave a field oxide film 5 as shown in Figures 2e. An $SiO_2$ film 6 is deposited for a gate oxide film to a thickness of 7,500 Å (750 nm) by chemical vapor deposition (Figure 2f). Holes for electrode contacts (each having the dimensions of 100×80 (μm)) are provided as shown in Figure 2g by photo-etching. After evaporating Al onto the whole surface of the resultant substrate, the Al is worked by photoetching to form a source electrode 7, a drain electrode 8 and a gate electrode 9 (Figure 2h). Thereafter, heat treatment at 400°C for 30 minutes is carried out in an $H_2$ atmosphere.

By these steps, a thin-film MOS field effect transistor of the structure in which the channel is provided in the surface layer of the polycrystalline silicon film is produced. This semiconductor device exhibits good and stable characteristics as a transistor.

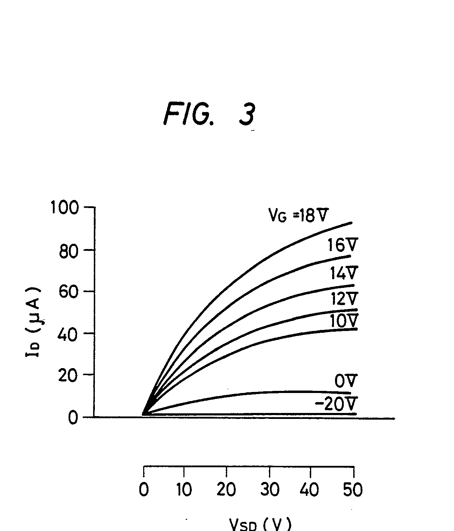

Figure 3 shows a characteristic at room temperature of a MOSFET which was manufactured experimentally. The characteristic is the drain current $I_D$—versus—drain voltage $V_{DS}$ characteristic with the gate voltage $V_G$ being a parameter.

MOSFETS were produced using polycrystalline Si films having various structures. The threshold voltages of these MOSFETs were compared, and the results are listed in the following table.

0 043 691

TABLE

| Preferred orientation | Thickness (µm) | Threshold voltage | Variation of threshold voltages | Deposition temperature (°C) |
|---|---|---|---|---|
| <100> Strong | 1 | −5 | ±15 | 600 |
| <100> Strong<br><110> Medium | 1 | −5 | ±15 | 600 |
| <100> Medium<br><110> Medium | 0.7 | −5 | ±15 | 600 |
| <100> Weak<br><110> Medium | 0.55 | 10 | ±20 | 600 |
| <110> Medium | 0.5 | 15 | ±20 | 600 |
| Random orientation | 0.3 | 45 | ±20 | 600 |
| Amorphous | 1.0 | incapable of high-speed operation | — | 350 |

Although above examples describe MOSFETs, the invention is applicable to other semiconductor devices, for example, bipolar transistors, diodes, and ICs (integrated circuits) or LSIs (large-scale integrated circuits) and such devices may be present in combination.

Although p-type silicon has been described n-type silicon can be produced by doping the silicon film with an appropriate impurity.

**Claims**

1. A semiconductor device comprising a polycrystalline semiconductor film (2) which is formed on an amorphous or polycrystalline substrate (1) characterized in that the semiconductor material of said film (2) has a crystal system of a diamond structure, the structure having a <100> preferred orientation, or a mixed <100> and <110> preferred orientation.

2. A semiconductor device according to claim 1 wherein said semiconductor material is silicon.

3. A semiconductor device according to claim 1 or claim 2, wherein said film (2) has been formed by vacuum evaporation under a high vacuum of below $1 \times 10^{-8}$ Torr ($1.3 \times 10^{-6}$ Pa) pressure.

4. A semiconductor device according to any one of claims 1 to 3 wherein said film (2) has a thickness of at least 500 nm.

5. A semiconductor device according to any one of claims 1 to 4 wherein in said film (2) a region (4) in which carriers move is disposed at a surface of said film (2) opposite the surface facing said substrate (1).

6. A semiconductor device according to any one of claims 1 to 5 wherein said structure has a <100> preferred orientation.

7. A semiconductor device according to any one of claims 1 to 6 which is a field effect transistor having channel regions formed in said film (2).

8. A semiconductor device according to claim 7, wherein said polycrystalline semiconductor film (2) has source and drain regions (4) formed in its surface region remote from the substrate and has a gate insulator layer selectively formed on its surface remote from the substrate and electrodes (7, 8, 9) are formed respectively on the source region, the drain region and the gate insulator layer.

9. A semiconductor device according to any one of the preceding claims wherein the softening point of said substrate is not more than 820°C.

10. A semiconductor device according to any one of the preceding claims wherein said substrate (1) is made of glass.

**Patentansprüche**

1. Halbleiterbauelement mit einer auf einem amorphen oder polykristallinen Substrat (1) ausgebildeten polykristallinen Halbleiterschicht (2),
dadurch gekennzeichnet, daß Halbleitermaterial der Schicht (2) ein Kristallsystem mit Diamantstruktur aufweist, wobei die Struktur eine <100>-Vorzugsrichtung oder eine gemischte <100>- und <110>-Vorzugsrichtung hat.

2. Halbleiterbauelement nach Anspruch 1, wobei das Halbleitermaterial Silicium ist.

3. Halbleiterbaulement nach Anspruch 1 oder 2, wobei die Schicht (2) durch Vakuumaufdampfung in einem Hochvakuum bei einem Druck unter $1 \times 10^{-8}$ Torr ($1,3 \times 10^{-6}$ Pa) erzeugt worden ist.

4. Halbleiterbauelement nach einem der Ansprüche 1 bis 3, wobei die Schicht (2) eine Dicke von mindestens 500 nm hat.

5. Halbleiterbauelement nach einem der Ansprüche 1 bis 4, wobei in der Schicht (2) ein Bereich (4), in dem sich Ladungsträger bewegen, an einer Oberfläche der Schicht (2) angeordnet ist, die zu der dem Substrat (1) zugwandten Oberfläche entgegengesetzt ist.

6. Halbleiterbauelement nach einem der Ansprüche 1 bis 5, wobei die Struktur eine <100>-Vorzugsrichtung aufweist.

7. Halbleiterbauelement nach einem der Ansprüche 1 bis 6, das ein Feldeffekttransistor mit in der Schicht (2) ausgebildeten Kanalbereichen ist.

8. Halbleiterbauelement nach Anspruch 7, wobei die polykristalline Halbleiterschicht (2) in ihrem von dem Substrat abgewandten Oberflächenbereich ausgebildete Source- und Drain-Bereiche (4), eine auf ihrer von dem Substrat abgewandten Oberfläche selektiv ausgebildete Gate-Isolierschicht sowie auf dem Source-Bereich, dem Drain-Bereich und der Gate-Isolierschicht jeweils ausgebildete Elektroden (7, 8, 9) aufweist.

9. Halbleiterbauelement nach einem der vorhergehenden Ansprüche, wobei der Erweichungspunkt des Substrats nicht über 820°C liegt.

10. Halbleiterbauelement nach einem der vorhergehenden Ansprüche, wobei das Substrat (1) aus Glas besteht.

**Revendications**

1. Dispositif semiconducteur comportant une pellicule semiconductrice polycristalline (2) qui est formée sur un substrat amorphe ou polycristallin (1), caractérisé en ce que le matériau semiconducteur de ladite pellicule (2) possède un système cristallin ayant la structure du diamant, cette structure possédant une orientation préférée <100> ou une orientation préférée mixte <100> et <110>.

2. Dispositif semiconducteur selon la revendication 1, dans lequel le matériau semiconducteur est le silicium.

3. Dispositif semiconducteur selon la revendication 1 ou 2, dans lequel ladite pellicule (2) a été formée par évaporation sous un vide poussé correspondant à une pression inférieure à $1 \times 10^{-8}$ torr ($1,3 \times 10^{-6}$ Pa).

4. Dispositif semiconducteur selon l'une quelconque des revendications 1 à 3, dans lequel ladite pellicule (2) possède une épaisseur égale au moins à 500 nm.

5. Dispositif semiconducteur selon l'une quelconque des revendications 1 à 4, dans lequel, à l'intérieur de ladite pellicule (2), une région (4), dans laquelle des porteurs se déplacent, est disposée dans une surface de ladite pellicule (2) à l'opposé de la surface tournée vers ledit substrat (1).

6. Dispositif semiconducteur selon l'une quelconque des revendications 1 à 5, dans lequel ladite structure possède une orientation préférée <100>.

7. Dispositif semiconducteur selon l'une quelconque des revendications 1 à 6, qui est un transistor à effet de champ possédant des régions de canal formées dans ladite pellicule (2).

8. Dispositif semiconducteur selon la revendication 7, dans lequel ladite pellicule semiconductrice polycristalline (2) possède des régions de source et de drain (4) formées dans sa région superficielle éloignée du substrat et possède une couche formant isolant de grille formée de façon sélective sur sa surface distante du substrat, et des électrodes (7, 8, 9) sont formées respectivement sur la région de source, sur la région de drain et sur la couche formant isolant de grille.

9. Dispositif semiconducteur selon l'une quelconque des revendications précédentes, dans lequel le point de ramollissement dudit substrat n'est pas supérieur à 820°C.

10. Dispositif semiconducteur selon l'une quelconque des revendications précédentes, dans lequel ledit substrat (1) est constitué par du verre.

## FIG. 1

FIG. 2a

FIG. 2b

FIG. 2c

FIG. 2d

FIG. 2e

FIG. 2f

FIG. 2g

FIG. 2h

## FIG. 3